(19) Europäisches Patentamt

European Patent Office

Office européen des brevets

(11) EP 1 717 936 A2

(12) EUROPEAN PATENT APPLICATION

(43) Date of publication:
02.11.2006 Bulletin 2006/44

(51) Int Cl.:
H02K 41/035 (2006.01)    H02K 33/18 (2006.01)

(21) Application number: 06006559.6

(22) Date of filing: 29.03.2006

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK YU

(30) Priority: 27.04.2005 JP 2005130309

(71) Applicant: SONY CORPORATION
Tokyo (JP)

(72) Inventor: Ishikawa, Hiroichi
Tokyo (JP)

(74) Representative: Müller - Hoffmann & Partner
Patentanwälte,
Innere Wiener Strasse 17
81667 München (DE)

(54) **Vibrating device for jet flow generating including a voice coil motor**

(57) A vibrating device (15) configured to vibrate a gas inside a chassis (1) to discharge the gas in a pulsating flow through an opening (12a,12b) formed in the chassis (1) includes a frame (4), a vibrating plate (3), a supporting member (6) that is attached to the frame (4) and that is configured to support the vibrating plate (3) in a manner such that the vibrating plate (3) is vibratable, and a driving mechanism (5) that is configured to drive the vibrating plate (3) and that includes a magnetic circuit member (8,14,18) attached to the frame (4) and a voice coil body (19,9,17) attached to the vibrating plate (3). The voice coil body (19,9,17) is configured to prevent the voice coil body (19,9,17) from contacting the magnetic circuit member (8,14,18) when the vibrating plate (3) is vibrating and is movable by means of a magnetic field generated by the magnetic circuit member (8,14,18).

FIG. 2

EP 1 717 936 A2

**Description**

CROSS REFERENCES TO RELATED APPLICATIONS

The present invention contains subject matter related to Japanese Patent Application JP 2005-130309 filed in the Japanese Patent Office on April 27, 2005, the entire contents of which are incorporated herein by reference.

BACKGROUND OF THE INVENTION

1. Field of the Invention

The present invention relates to a vibrating device configured to apply vibration to a gas to generate a jet flow of the gas and, more specifically, relates to a jet flow generating apparatus including the vibrating device and an electronic apparatus including the jet flow generating apparatus.

2. Description of the Related Art

A known problem accompanying the advancement of the performance of personal computers (PCs) is an increase in the amount of heat dispersed from heat-generating bodies, such as integrated circuits (ICs). Various technologies for dispersing heat have been proposed, and products employing such technologies have been produced. As a method of dispersing heat, a heat-radiating fin composed of metal, such as aluminum, is disposed in contact with an IC so that heat is transmitted from the IC to the fin. As another method of dispersing heat, a fan may be used to disperse heat by, for example, forcefully exhausting warm air in the chassis of a PC by guiding low-temperature air around the heat-generating body. Moreover, both a heat-radiating fin and a fan may be used to increase the contact area of the heat-generating body and air at the heat-radiating fin while forcing the fan to exhaust warm air around the heat-radiating fin.
However, forced exhaust of air by means of a fan causes a thermal boundary layer to be generated at the surface of the heat-radiating fin on the side of the lower flow. As a result, heat is not efficiently dispersed from the heat-radiating fin. To solve this problem, for example, the thickness of the thermal boundary layer can be reduced by increasing the wind velocity produced by the fan. However, in order to increase the wind velocity, the number of revolutions per unit time of the fan has to be increased. As a result, noise, such as wind noise, caused by the fan moving through the air is generated.
There is also a method of efficiently radiating heat from the heat-radiating fin to the outside air by breaking down the thermal boundary layer without use of a fan as airblowing means but, instead, using a vibration plate that reciprocates periodically (for example, refer to Japanese Unexamined Patent Application Publication Nos. 2000-223871, 2000-114760, 2-213200, and 3-116961). In particular, the apparatuses according to Japanese Unexamined Patent Application Publication Nos. 2-213200 and 3-116961 each include a vibrating plate that divides the space inside a chamber substantially in half, an elastic body that is provided in the chamber to support the vibrating plate, and vibrating means for vibrating the vibrating plate. In such an apparatus, for example, when the vibrating plate is displaced in the upward direction, the volume of the upper space of the chamber decreases. As a result, the pressure in the upper space in the chamber increases. Since the upper space communicates with the outside air through an exhaust port, the raised pressure in the upper space causes some of the air inside the upper space to be exhausted to the outside. At the same time, the volume of the lower space of the chamber on the opposite side of the vibrating plate from the upper space increases, causing the pressure in the lower space to decrease. Since the lower space communicates with the outside air through an exhaust port, the lowered pressure in the lower space causes some outside air in the vicinity of the exhaust port to be drawn into the lower space. In contrast, when the vibrating plate is displaced in a downward direction, the volume of the upper space of the chamber increases. As a result, the pressure in the upper space in the chamber decreases. Since the upper space communicates with the outside air through an exhaust port, the lowered pressure in the upper space causes some outside air in the vicinity of the exhaust port to be drawn into the upper space. At the same time, the volume of the lower space of the chamber on the opposite side of the vibrating plate from the upper space decreases, causing the pressure in the lower space to increase. The raised pressure in the lower space causes some of the air inside the upper space to be exhausted to the outside. The vibrating plate is driven by, for example, electromagnetic force. By driving the vibrating plate in such a reciprocating manner, a movement for exhausting air inside to the chamber to the outside and a movement for taking outside air into the chamber are repeated periodically. As a result, a pulsating flow of air is generated by the periodical reciprocating movement of the vibrating plate. This pulsating flow impinges upon a heat-generating body, such as a heat-radiating fin (heat sink), causing the thermal boundary layer at the surface of the heat-radiating fin to be efficiently broke down. Consequently, the heat-radiating fin is efficiently cooled.

## SUMMARY OF THE INVENTION

However, when the amount of heat generated by the heat-generating body is great, a device having a high cooling ability, i.e., a device having a great gas discharge amount, will be required. In particular, since the amount of heat generated by a central processing unit (CPU) has been increasing every year, it is necessary to efficiently cool a CPU. To increase the gas discharge amount, the amplitude of the vibrating plate can be increased. However, if the amplitude is increased too much, the vibrating plate will bend, and vibration will not be efficiently transmitted to the gas. As a result, extreme noise will be generated.

Embodiments of the present invention address the above-identified problems and other problems associated with known apparatuses to provide a vibrating device capable of suppressing noise without reducing the gas discharge amount, a jet flow generating apparatus including the vibrating device, and an electronic apparatus including the jet flow generating apparatus.

A vibrating device according to an embodiment of the present invention is configured to vibrate a gas inside a chassis to discharge the gas in a pulsating flow through an opening formed in the chassis and includes a frame, a vibrating plate, a supporting member that is attached to the frame and that is configured to support the vibrating plate in a manner such that the vibrating plate is vibratable, and a driving mechanism that is configured to drive the vibrating plate and includes a magnetic circuit member attached to the frame and a voice coil body. The voice coil body is configured to prevent the voice coil body from contacting the magnetic circuit member when the vibrating plate is vibrating and is attached to the vibrating plate in a manner such that the voice coil body is movable by means of a magnetic field generated by the magnetic circuit member.

Since the driving mechanism according to an embodiment of the present invention includes a voice coil body configured to prevent the voice coil body from coming into contact with the magnetic circuit member when the vibrating plate is vibrating, unwanted noise caused by the voice coil body contacting the magnetic circuit member is suppressed. Accordingly, noise can be suppressed, for example, while maintaining a predetermined gas discharge amount without reducing the frequency and amplitude of the vibrating plate.

The gas is, for example, air. However, the gas is not limited to air and, instead, may be an inactive gas, such as nitrogen gas, helium gas, or argon gas, or any other gas.

According to an embodiment of the present invention, the magnetic circuit member includes a magnet magnetized in the vibration direction of the vibrating plate and a yoke having a magnetic plate attached to the vibrating plate side of the magnet at a first position along the vibration direction and a magnetic cylinder forming a magnetic gap between the magnet plate and forming a space between the magnet. The voice coil body includes a tip, a coil, and a bobbin on which the coil is wound. The voice coil body moves in the vibration direction in the space to prevent at least one of the tip and the coil from coming into contact with the magnetic circuit member. The tip of the voice coil body may contact the magnetic circuit member if the voice coil body tilts in a direction other than the vibration direction. Therefore, the voice coil body can be moved so that at least one of the tip or the coil does not contact the magnetic circuit member.

The supporting member supports the vibrating plate at a second position that is a position along the vibration direction on a plane substantially orthogonal to the vibration direction of the vibrating plate. The tip of the voice coil body is disposed at a third position a predetermined distance away from the second position in the vibration direction. The predetermined distance is determined from a function of a third length that is the sum of a first length and a second length in which the first length is the minimum length from the center of the vibrating plate to the peripheral edge on the plane and the second length is half the length from the peripheral edge to the frame in the same direction as the first length.

More specifically, the following formula is satisfied:

$$d < [(G-t)R]/(2X)$$

where d [mm] represents the predetermined distance, R [mm] represents the third length, G [mm] represents the magnetic gap, t [mm] represents the thickness of the voice coil body in the space, and X [mm] represents the displacement in the vibration direction of the supporting member when the vibrating plate moves in a direction other than the vibration direction, the supporting member being disposed away from the center of the vibrating plate by a distance equal to the third length.

A practical length for the third length R is in the range of 5 to 100 mm when the size of the electronic apparatus including the vibrating device varies from a small portable audio apparatus to a large display apparatus.

In particular, it is desirable that, when the third length R is in the range of 10 to 40 mm, the predetermined distance d be in the range of 0 to 20 mm or 0 to 10 mm. For example, when a portable apparatus is to be provided as the electronic apparatus including the vibrating device, the most practical third length R for the portable apparatus is in the range of 10 to 40 mm. More desirable, the third length R is in the range of 15 to 35 mm. In this case, when the above-mentioned formula is applied, the distance d is in the range of 0 to 20 mm or 0 to 10 mm. When distance d equals zero, the supporting member will support the vibrating plate on the plane where the magnetic plate is disposed, reducing the thickness of the vibrating device.

The supporting member supports the vibrating plate at a second position that is a predetermined distance away from the first position in the vibration direction on a plane substantially orthogonal to the vibration direction. When the magnetic gap is smaller than the width of the space on the plane, the predetermined length is determined from a function of a third length that is the sum of a first length and a second length, where the first length is the minimum length from the center of the vibrating plate to the peripheral edge on the plane and the second length is half the length from the peripheral edge to the frame in the direction of the first length.

In this case, also, the following formula is satisfied:

$$d < [(G-t)R] / (2X)$$

, where d [mm] represents the predetermined distance, R [mm] represents the third length, G [mm] represents the magnetic gap, t [mm] represents the thickness of the voice coil body in the space, and X [mm] represents the displacement in the vibration direction of the supporting member when the vibrating plate moves in a direction other than the vibration direction, the supporting member being disposed away from the center of the vibrating plate by a distance equal to the third length.

In this case, when a practical configuration is considered, it is desirable that, when the third length R is in the range of 10 to 40 mm, the predetermined distance d is in the range of 0 to 10 mm or 0 to 5 mm.

According to an embodiment of the present invention, the voice coil body is attached to the vibrating plate at a fourth position that is a position different from the second position along the vibrating direction. The fourth position is closer to the magnet than the second position or the fourth position is further from the magnet than the second position. In such case, the vibrating plate does not have to be flat and may be cone-shaped or a side plate may be provided. By providing a three-dimensional vibrating plate, instead of a flat vibrating plate, the rigidity of the vibrating plate is increased, and bending of the vibrating plate can be suppressed to enable efficient vibration. As a result, the gas discharge efficiency is increased. In particular, if the fourth position is provided opposite to the first position in the vibration direction relative to the second position, the thickness of the vibrating device can be reduced.

The side plate of the vibrating plate may be vertically disposed substantially parallel to the vibration direction of the vibrating plate but is not limited to a vertical position. The side plate may be disposed as a continuous structure. In other words, the side plate may be disposed at the periphery of a flat plate disposed substantially orthogonal to the vibration direction or more inward than at the periphery of the flat plate.

According to an embodiment of the present invention, the vibrating plate includes a first flat plate supported by the supporting member, and a second flat plate attached to the voice coil body and substantially parallel to the first flat plate. In this case, also, the vibrating plate is three-dimensional, instead of being flat, and the rigidity of the vibrating plate can be increased.

According to an embodiment of the present invention, the voice coil body is attached to the vibrating plate at substantially the same position as the second position in the vibration direction. In such a case, the vibrating plate is often flat. However, the shape is not limited thereto.

According to an embodiment of the present invention, the driving mechanism includes a vibrating plate that has a side plate supported by a supporting member and a flat plate attached to a voice coil body. The driving mechanism includes an electric supply line that is connected to the voice coil body and disposed along the first flat plate and the second flat plate. According to such a configuration, the vibrating plate and the electric supply line move as a unit, preventing the electric supply line from breaking when the vibrating plate vibrates.

According to an embodiment of the present invention, the cross-section of vibrating plate along a plane substantially orthogonal to the vibration direction is shaped as one of a circle, an oval, a polygon, and a polygon with rounded corners. A polygon with rounded corners is an area surrounded with straight lines and curved lines and may be any polygon having rounded corners.

A jet flow generating apparatus according to an embodiment of the present invention includes a frame, a chassis that has an opening and is configured to support the frame and accommodate gas inside, a vibrating plate configured to vibrate to discharge the gas in a pulsating flow through the opening, a supporting member that is attached to the frame and is configured to support the vibrating plate in a manner such that the vibrating plate is vibratable, and a driving mechanism that is configured to drive the vibrating plate and includes a magnetic circuit member attached to the frame, and a driving mechanism that is configured to drive the vibrating plate and that includes a magnetic circuit member attached to the frame and a voice coil body attached to the vibrating plate. The voice coil body is configured to prevent the voice coil body from contacting the magnetic circuit member when the vibrating plate is vibrating and is attached to the vibrating plate in a manner such that the voice coil body is movable by means of a magnetic field generated by the magnetic circuit member.

A jet flow generating apparatus according to another embodiment of the present invention includes a chassis that has an opening and that accommodates gas inside, a vibrating plate configured to vibrate to discharge the gas in a pulsating flow through the opening, a supporting member that is attached to the chassis and is configured to support the vibrating plate in a manner such that the vibrating plate is vibratable, and a driving mechanism that is configured to drive the vibrating plate and includes a magnetic circuit member attached to the chassis and a voice coil body attached to the vibrating plate. The voice coil body is configured to prevent the voice coil body from contacting the magnetic circuit member when the vibrating plate is vibrating and is attached to the vibrating plate in a manner such that the voice coil body is movable by means of a magnetic field generated by the magnetic circuit member.

An electronic apparatus according to an embodiment of the present invention includes a heat-generating body, a frame, a chassis that has an opening and that is configured to support the frame and accommodate gas inside, a vibrating plate configured to vibrate to discharge the gas in a pulsating flow through the opening toward the heat-generating body, a supporting member that is attached to the frame and that is configured to support the vibrating plate in a manner such that the vibrating plate is vibratable, and a driving mechanism configured to drive the vibrating plate and includes a magnetic circuit member attached to the frame and a voice coil body attached to the vibrating plate. The voice coil body is configured to prevent the voice coil body from contacting the magnetic circuit member when the vibrating plate is vibrating and is attached to the vibrating plate in a manner such that the voice coil body is movable by means of a magnetic field generated by the magnetic circuit member.

An electronic apparatus according to another embodiment of the present invention includes a heat-generating body, a chassis that has an opening and that accommodates gas inside, a vibrating plate configured to vibrate to discharge the gas in a pulsating flow through the opening toward the heat-generating body, a supporting member that is attached to the chassis and that is configured to support the vibrating plate in a manner such that the vibrating plate is vibratable, and a driving mechanism that is configured to drive the vibrating plate and that includes a magnetic circuit member attached to the chassis and a voice coil body attached to the vibrating plate. The voice coil body is configured to prevent the voice coil body from contacting the magnetic circuit member when the vibrating plate is vibrating and is attached to the vibrating plate in a manner such that the voice coil body is movable by means of a magnetic field generated by the magnetic circuit member.

The electronic apparatus may be a computer, such as a laptop PC or a desk top PC, a personal digital assistance (PDA), an electronic dictionary, a camera, a display apparatus, an audio/visual apparatus, a mobile phone, a game apparatus, a car navigation apparatus, a robot, or any other electrical appliance. The heat-generating body may be an electronic component, such as an IC or a resistor, or a heat-radiating fin (heat sink). However, the heat-generating body is not limited thereto and may be any type of device that generates heat.

As described above, according to an embodiment of the present invention, generation of noise can be suppressed without reducing the gas discharge amount.

BRIEF DESCRIPTION OF THE DRAWINGS

Fig. 1 illustrates a perspective view of a jet flow generating apparatus according to an embodiment of the present invention;
Fig. 2 illustrates a cross-sectional view of the jet flow generating apparatus shown in Fig. 1;
Fig. 3 illustrates a cross-sectional view of the actuator shown in Fig. 1;
Fig. 4 illustrates the magnetic field generated by the actuator shown in Fig. 3;
Fig. 5 illustrates a cross-sectional view of the jet flow generating apparatus having one chamber;
Fig. 6 illustrates a cross-sectional view of a vibrating device according to another embodiment of the present invention;
Fig. 7 illustrates a cross-sectional view of a speaker;
Fig. 8 illustrates a cross-sectional view of the actuator and the vibrating plate that are main components of the vibrating device;
Fig. 9 illustrates a voice coil body and a vibrating plate in a tilted state when the vibrating plate vibrates in the direction of vibration;
Fig. 10 illustrates the amount of change in Y, shown in Fig. 9;
Fig. 11 illustrates a cross-sectional view of a vibrating device according to another embodiment of the present invention;
Fig. 12 illustrates a cross-sectional view of a vibrating device according to another embodiment of the present invention;
Fig. 13 illustrates a cross-sectional view of a vibrating device according to another embodiment of the present invention;

Fig. 14 illustrates a cross-sectional view of a vibrating device according to another embodiment of the present invention;

Fig. 15 illustrates a vibrating plate of the vibrating device shown in Fig. 14 at a tilted state caused by horizontal vibration;

Fig. 16 illustrates an enlarged cross-sectional view of an actuator of the vibrating device shown in Fig. 14;

Fig. 17 illustrates an enlarged cross-sectional view of an actuator of the vibrating device shown in Fig. 15;

Fig. 18 illustrates a cross-sectional view of a vibrating device according to another embodiment of the present invention;

Fig. 19 illustrates a vibrating plate of the vibrating device shown in Fig. 18 at a tilted state caused by horizontal vibration;

Fig. 20 illustrates the amount of change in Y, shown in Fig. 9;

Fig. 21 illustrates a cross-sectional view of a vibrating device according to another embodiment of the present invention;

Fig. 22 illustrates a cross-sectional view of a jet flow generating apparatus according to another embodiment of the present invention;

Fig. 23 illustrates a cross-sectional view of a jet flow generating apparatus according to another embodiment of the present invention;

Fig. 24 illustrates a cross-sectional view of a modification of the jet flow generating apparatus shown in Fig. 23;

Figs. 25A to 25E illustrate plan views of the shape of vibrating plates according to another embodiment of the present invention;

Figs. 26A to 26E illustrate plan views of the vibrating plates and elastic supporting members according to the other embodiments of the present invention;

Fig. 27 illustrates a cross-sectional view of a vibrating device according to another embodiment of the present invention;

Fig. 28 illustrates a plan view of a chassis of a jet flow generating apparatus according to another embodiment of the present invention; and

Fig. 29 illustrates a perspective view and a partial broken view of a laptop personal computer including the jet flow generating apparatus shown in Fig. 1.

DESCRIPTION OF THE PREFERRED EMBODIMENTS

Embodiments of the present invention will be described below with reference to the drawings.

Embodiments

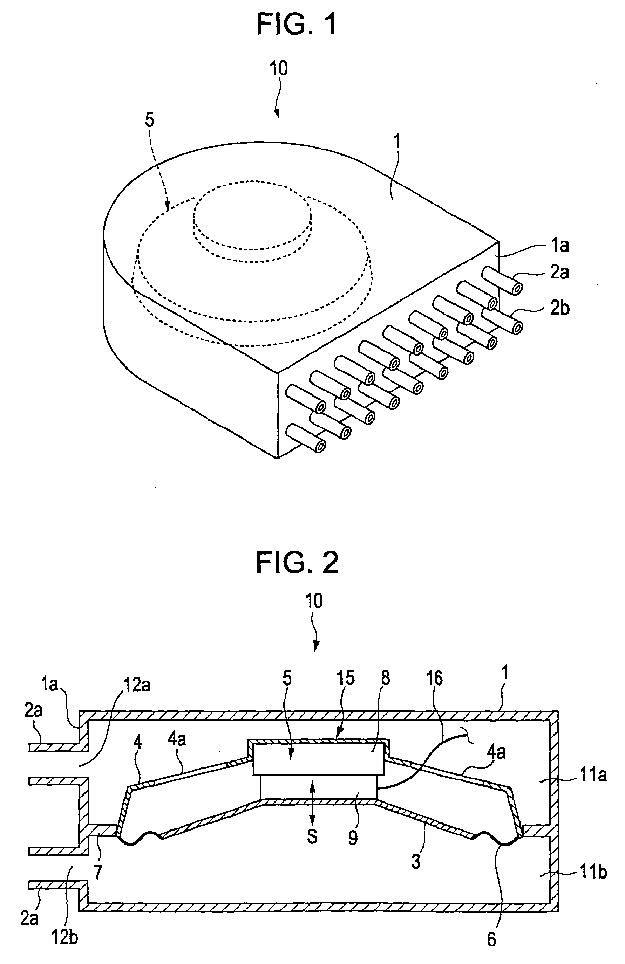

Fig. 1 illustrates a perspective view of a jet flow generating apparatus according to a first embodiment of the present invention. Fig. 2 illustrates a cross-sectional view of the jet flow generating apparatus shown in Fig. 1.

A jet flow generating apparatus 10 includes a chassis 1 whose rear part is rounded and a vibrating device 15 disposed inside the chassis 1. On a front surface 1a of the chassis 1, rows of nozzles 2a and 2b are provided. As shown in Fig. 2, the inside of the chassis 1 is divided into an upper chamber 11a and a lower chamber 11b by an attachment part 7 to which the vibrating device 15 is attached. On the front surface 1a of the chassis 1, where the nozzles 2a and 2b are provided, openings 12a and 12b are formed at positions corresponding to the nozzles 2a and 2b, respectively. In this way, the upper chamber 11a and the lower chamber 11b communicate with the outside the chassis 1. The upper chamber 11a and the lower chamber 11b have substantially the same volume. Since the vibrating device 15 is disposed in the upper chamber 11a, the upper chamber 11a has a greater thickness in the vertical direction in Fig. 2 than that of the lower chamber 11b. In this way, the amount of air sent out alternately from the nozzles 2a and 2b is equal, improving the quietness of the vibrating device.

The vibrating device 15 has a structure similar, for example, to a speaker. The vibrating device 15 includes a frame 4, an actuator 5 that is mounted on the frame 4 and functions as a driving mechanism, and a vibrating plate 3 that is attached to the frame 4 by an elastic supporting member 6. The frame 4 has a circulation port 4a for allowing the air inside the chassis 1 to flow in and out of the frame 4. The circulation port 4a may include plurality of ports or may be at least one elongated hole.

The vibrating plate 3 is composed of, for example, resin, paper, or metal. If the vibrating plate 3 is composed of paper, the weight of the vibrating plate 3 can be significantly reduced. Paper cannot be shaped as freely as resin. However, paper is advantageous in reducing the weight of the apparatus. If the vibrating plate 3 is composed of resin, the vibrating plate 3 can be molded into any desired shape. If the vibrating plate 3 is composed of metal, some types of metal, such as magnesium, are light and can be molded by injection. Therefore, a desirable metal can be selected to compose the vibrating plate 3.

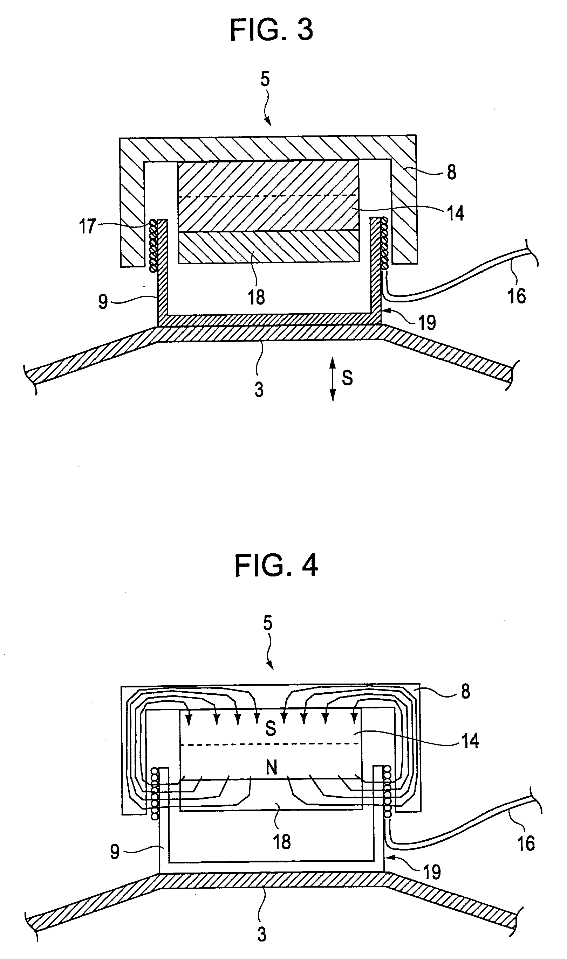

Fig. 3 is an enlarged cross-sectional view of the actuator 5. The actuator 5 includes, for example, a magnet 14 that is magnetized in the vibration direction S of the vibrating plate 3 and a disk-shaped flat yoke 18 that is attached to the magnet 14, wherein the magnet 14 and the flat yoke 18 are disposed on the inner side of a cylindrical yoke 8. The magnet 14, the cylindrical yoke 8, and the flat yoke 18 generate a magnetic field, as shown in Fig. 4, so as to constitute a magnetic circuit. Hereinafter, the magnet 14, the cylindrical yoke 8, and the flat yoke 18 are also referred to as magnetic circuit members. A voice coil body 19 moves into and out from the space formed between the magnet 14 and the cylindrical yoke 8. The voice coil body 19 is a coil bobbin 9 on which a coil 17 is wound. In other words, the actuator 5 is constituted of a voice coil motor. The coil 17 receives electric signals from, for example, a driving IC, not shown in the drawings, via an electric supply line 16. The cylindrical yoke 8 is fixed at the center on the inside of the frame 4. The coil bobbin 9 is fixed on the surface of the vibrating plate 3.

The flat yoke 18 is, for example, disk-shaped, as mentioned above. However, the shape of the flat yoke 18 is not limited and may instead by oval or rectangular. The cylindrical yoke 8 is, for example, cylindrical, as mentioned above. However, the cylindrical yoke 8 may instead be a prism. It may be desirable to provide the cylindrical yoke 8 and the flat yoke 18 so that the cross-sectional shapes of the surfaces of the cylindrical yoke 8 and the flat yoke 18 taken along a direction orthogonal to the vibration direction S are the same as that of the opposing surface of the vibrating plate 3.

The chassis 1 is composed of, for example, resin, rubber, or metal. Resin and rubber are suitable for mass-production since they can be easily molded. If the chassis 1 is composed of resin or rubber, noise generated when the actuator 5 is driven and wind noise generated by the vibration of the vibrating plate 3 can be suppressed. By composing the chassis 1 with resin or rubber, the sound damping rate is improved and noise can be suppressed. Moreover, by composing the chassis 1 with resin or rubber, the weight and production cost of the chassis 1 can be reduced. If the chassis 1 is composed of resin by injection molding, the nozzles 2a and 2b can be formed as a single unit with the chassis 1. If the chassis 1 is composed of a material having high heat conductivity, such as metal, heat generated at the actuator 5 can be transmitted to the chassis 1 and then dispersed outside of the chassis 1. The metal may be aluminum or copper. When heat conductivity is taken into consideration, not only metal but also carbon is suitable. It is also possible to use magnesium, which is a metal that can be molded by injection. If the magnetic field generated by the magnetic circuit of the actuator 5 affects other devices in the apparatus, a measure must be taken to prevent leakage of the magnetic field. As one measure, the chassis 1 may be composed of a magnetic material, such as iron. In this way, leakage of the magnetic field can be significantly reduced. If the apparatus is to be used in a high-temperature environment or under special conditions, the chassis 1 may be composed of ceramic.

As described above, when the chassis 1 is composed of a material having high heat conductivity so as to enable heat dispersion, it is desirable to also compose the frame 4 of a material having high heat conductivity. In such a case also, the frame 4 is composed of metal or carbon. However, when heat conductivity is not taken into consideration, the frame 4 may be composed of, for example, resin. If resin is used, a light-weight frame can be composed by injection molding at low production costs. Part of the frame 4 may be composed of a magnetic material. The same magnetic material may be used to compose the yokes of the actuator 5 to increase the magnetic flux density.

The elastic supporting member 6 is composed of, for example, rubber or resin. The elastic supporting member 6 has a bellows-like structure and is circular when viewed from the top. The vibrating plate 3 is mainly supported by the actuator 5. However, the elastic supporting member 6 also supports the vibrating plate 3 to prevent horizontal vibration, i.e., vibration in the direction orthogonal to the vibration direction S of the vibrating plate 3. As described above, the elastic supporting member 6 separates the upper chamber 11a and the lower chamber 11b and prevents air from flowing between the upper chamber 11a and the lower chamber 11b when the vibrating plate 3 vibrates. It is desirable that the bellows-like elastic supporting member 6 has one mountain fold and one valley fold, as shown in Fig. 2. If only a single mountain fold or only a single valley fold is provided, the elastic supporting member 6 will be long in the vertical direction in Fig. 2, increasing the thickness of the actuator 5. On the other hand, if a plurality of mountain folds and valley folds is provided, the vibration of the vibrating plate 3 will cause the elastic supporting member 6 to move in a complicated manner, reducing the efficiently of the actuator 5.

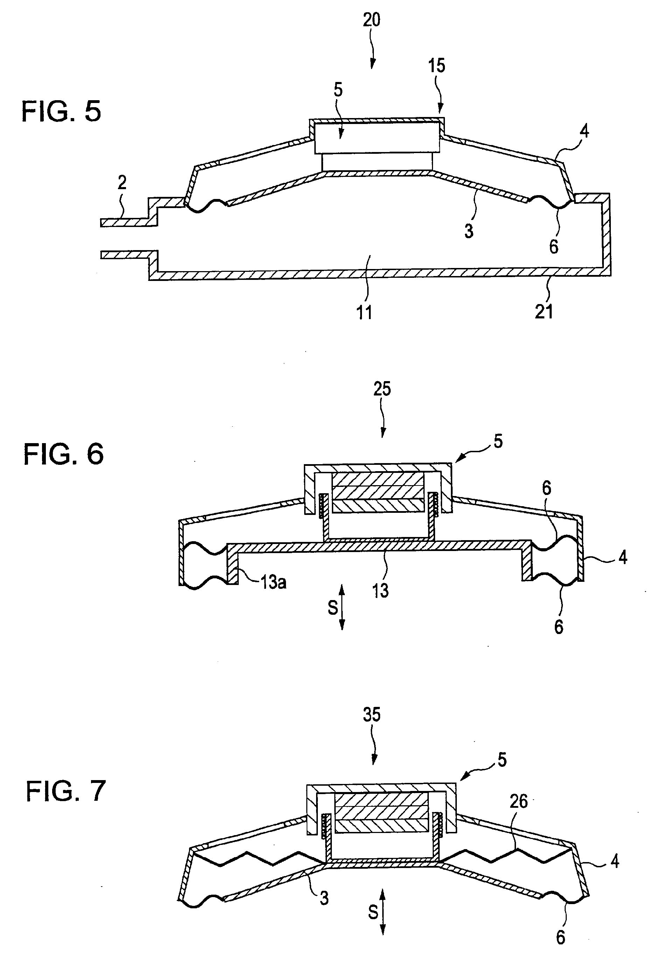

However, the structure of the elastic supporting member 6 is not limited to that shown in Fig. 6 and may have only one mountain fold or only one valley fold or may have a plurality of mountain folds and valley folds. Moreover, the elastic supporting member 6 may have a flat cross-section, instead of the S-shaped cross-section, as shown in Fig. 2.

In the above-described structure, the nozzles 2a and 2b are provided on the chassis 1. However, instead, a single opening may be formed on the chassis 1.

The operation of the jet flow generating apparatus 10 having the above-described structure will be described below.

When, for example, a sinusoidal alternating current voltage is applied to the actuator 5, the vibrating plate 3 vibrates in a sinusoidal pattern. As a result, the volumes of the upper chamber 11a and the lower chamber 11b change. As the volumes of the upper chamber 11a and the lower chamber 11b change, the pressure of the upper chamber 11a and the lower chamber 11b change. As a result, a pulsating flow of air is generated through the nozzles 2a and 2b. For example, when the vibrating plate 3 is displaced in a direction that causes the volume of the upper chamber 11a to be increased, the pressure in the upper chamber 11a decreases, whereas the pressure in the lower chamber 11b increases.

In this way, air outside the chassis 1 flows into the upper chamber 11a through the nozzles 2a, whereas the air in the lower chamber 11b is discharged to the outside through the nozzles 2b. In contrast, when the vibrating plate 3 is displaced in a direction that causes the volume of the upper chamber 11a to be decreased, the pressure in the upper chamber 11a increases, whereas the pressure in the lower chamber 11b decreases. In this way, the air in the lower chamber 11a is discharged to the outside through the nozzles 2a, whereas air outside the chassis 1 flows into the upper chamber 11b through the nozzles 2b. When air is discharged from the nozzles 2a and 2b, the air pressure in the area near the nozzles 2a and 2b is reduced. As a result, air in the area near the nozzles 2a and 2b is sucked into the nozzles 2a and 2b. This generates a combined jet flow. By discharging this combined jet flow toward a heat-generating body and high-temperature areas, the heat-generating body and the high-temperature areas are cooled.

When air is discharged from the nozzles 2a and 2b, noise is generated from each of the nozzles 2a and 2b. However, the noise is damped since the sound wave of the noise generated at the nozzles 2a and the sound wave of the noise generated at the nozzles 2b have inverse phases. As a result, noise is reduced, and a quiet apparatus can be provided.

Fig. 5 illustrates a cross-sectional view of a jet flow generating apparatus 20 having only one chamber. In the jet flow generating apparatus 20, a chamber 11 is formed inside a chassis 21 by fitting a vibrating device 15 at the upper opening of the chassis 21. The chamber 11 communicates with outside nozzles 2. The shape of the chassis 21 may be similar to that shown in Fig. 1 wherein the rear part opposite to the nozzles 2 is rounded but is not limited thereto. In the jet flow generating apparatus 20 having such a structure, the vibrating plate 3 moves in the vertical direction in the drawing to send out or take in air from and into the chamber 11 according to the pressure change in the chamber 11. In this way, even when only one chamber 11 is provided, air can be discharged in a pulsating flow.

Next, the operation of the vibrating device 15 in the jet flow generating apparatus 10 or 20 will be described. Before describing the operation, prevention means for horizontal vibration of a vibrating plate will be described with reference to Figs. 6 and 7.

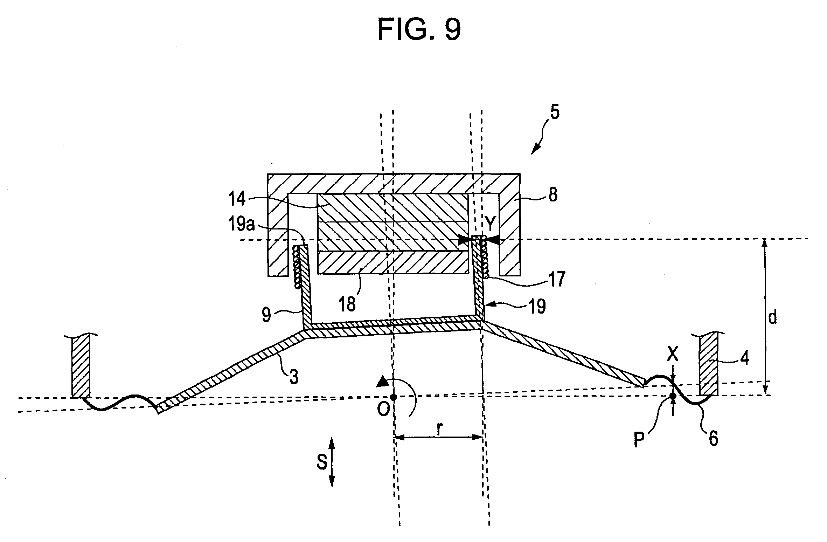

As shown in Fig. 6, a side plate 13a is vertically disposed around a vibrating plate 13 included in a vibrating device 25. The cross-section of the vibrating plate 13 along a plane orthogonal to the vibration direction S of the vibrating plate 13 is, for example, a circle. By providing the side plate 13a, the rigidity of the vibrating plate 13 is increased. As a result, the air pressured can be efficiently changed. Moreover, since the vibrating plate 13 will less likely be deformed, excess noise can be reduced. The side plate 13a does not directly contribute to preventing horizontal vibration. However, by providing the side plate 13a, two elastic supporting members 6 can be provided along the vibration direction S. As a result, compared to when only one elastic supporting member 6 is provided, the vibrating plate 13 is prevented from moving in a direction other than the vibration direction S, i.e., the vibrating plate 13 is prevented from tilting in the direction shown in Fig. 9 and from vibrating horizontally.

A vibrating device 35 shown in Fig. 7 includes an elastic supporting member 6 and another elastic supporting member (damper for prevention of horizontal vibration) 26 that prevents a vibrating plate 3 from vibrating horizontally. The vibrating device 35 has substantially the same structure as that of a typical speaker.

Since the vibrating devices 25 and 35 are capable of preventing horizontal vibration, they are advantageous in that noise generated by tilting of the voice coil body 19 due to horizontal vibration, as shown in Fig. 9, and contacting the magnetic circuit members can be suppressed.

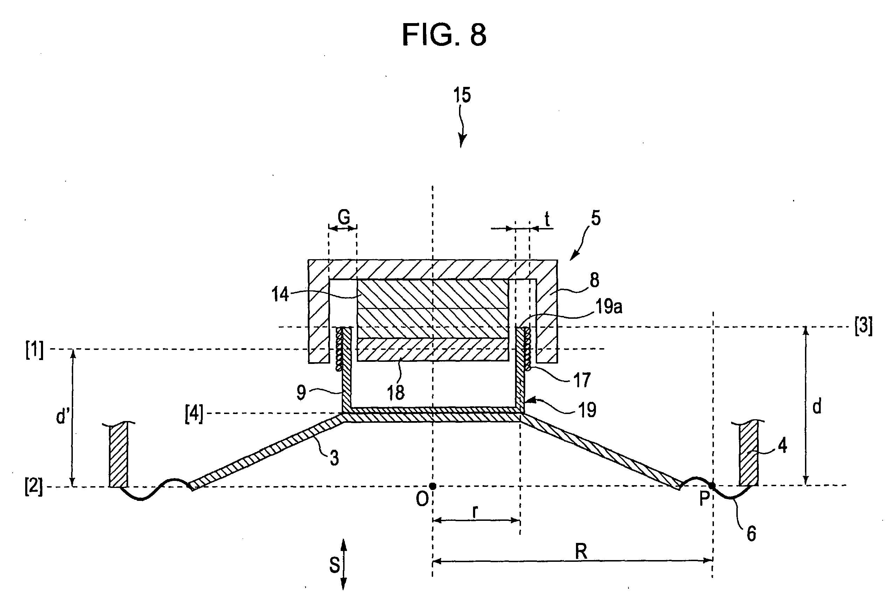

For example, if a jet flow generating apparatus is mounted on a portable electronic apparatus, such as a laptop PC, the jet flow generating apparatus is expected to be substantially the same size as a known axial fan in order to obtain a predetermined air discharge amount. As shown in the drawings, such as Fig. 2, if the vibrating plate 3 and the elastic supporting member 6 are circular, their diameter (e.g., Rx2 in Fig. 8 described below) is in the range of about 40 to 80 mm or about 50 to 80 mm, and the thickness of the chassis 1 is less than 20 mm. To achieve sufficient cooling ability with a jet flow generating apparatus having such a size, the inventor has discovered that it is desirable for the vibration of the vibrating plate to vibrate at about 4 mmp-p (peak to peak) (i.e., amplitude of about 2 mm). The amplitude can be reduced by increasing the frequency of the vibration. However, noise increases when the frequency is greater than 50 Hz. Therefore, to provide a low-noise jet flow generating apparatus that is capable of providing a predetermined air discharge amount, the amplitude should be about 4 mmp-p. A jet flow generating apparatus having a diameter of about 50 mm, a thickness less than 20 mm, and vibration of about 4 mmp-p can not be realized even for a speaker.

A speaker that includes a vibrating plate that has an amplitude of 4 mm is a low-range to mid-range woofer speaker. To obtain such a large amplitude, two elastic supporting members 6 are disposed far apart from each other, as shown in Fig. 6, and a damper 26 for preventing horizontal vibration is provided, as shown in Fig. 7. However, when the vibrating plate 13 is supported by two elastic supporting member 6, as shown in Figs. 6 and 7, the resistive force applied to the vibrating vibrating plate 13 becomes greater than the resistive force applied to a vibrating plate supported by only one elastic supporting member. Accordingly, the electric power consumed by the actuator 5 is increased. When only one elastic supporting member is provided, horizontal vibration is generated when a vibrating plate is vibrated with a great amplitude, and, as a result, noise is generated as described above.

Although the vibrating device 15 included in the above-described jet flow generating apparatus 10 or 20 includes only one elastic supporting member 6, the resistive force applied to the vibrating plate 3 is reduced while horizontal vibration is significantly reduced by means of the structure described below. In this way, the voice coil body 19 is prevented from coming into contact with the magnetic circuit members. The structure is described in detail below.

Fig. 8 illustrates a cross-sectional view of the actuator 15 and the vibrating plate 3 that are main components of the vibrating device 15. Fig. 9 illustrates the voice coil body 19 and the vibrating plate 3 in a tilted state when the vibrating plate 3 vibrates in the vibration direction S. The horizontal vibration of the vibrating plate 3 is quantized as below:

a point O is the center of the vibrating plate 3 in the horizontal direction of the drawing;

G [mm] represents the width of a space between the cylindrical yoke 8 and the magnet 14 (which is equivalent to a magnetic gap, as described below);

t [mm] represents the thickness of the voice coil body 19 in the space;

r [mm] represents the distance from the center O of the vibrating plate 3 to the vertical wall of the voice coil body 19;

R [mm] represents the sum of the distance from the center O of the vibrating plate 3 to the peripheral edge and half the distance from the peripheral edge to the frame 4 (i.e., the distance from the center O to a point P);

d [mm] represents the distance in the vibration direction S between a position [2] of the elastic supporting member 6 supporting the peripheral edge of the vibrating plate 3 (i.e., second position) to a position [3] of an tip 19a of the voice coil body 19 (i.e., third position);

the point P is the position on the elastic supporting member 6 half way between the distance from the peripheral edge of the vibrating plate 3 to the frame 4;

X [mm] represents the displacement of the point P in the vibration direction S (i.e., the original vibration direction) when the vibrating plate 3 is tilted (refer to Fig. 9); and

Y [mm] represents the displacement of the tip 19a of the voice coil body 19 in the direction orthogonal to the vibration direction S when the displacement of the point P equals X (refer to Fig. 9).

The thickness t is the sum of the thicknesses of the coil bobbin 9 and the coil 17 wound around the coil bobbin 9. For the configurations shown in Figs. 8 and 9, the width G of the above-described space is substantially the same as the gap between the flat yoke 18 and the cylindrical yoke 8, i.e., the magnetic gap, since the diameter of the flat yoke 18 is substantially equal to the diameter of the magnet 14.

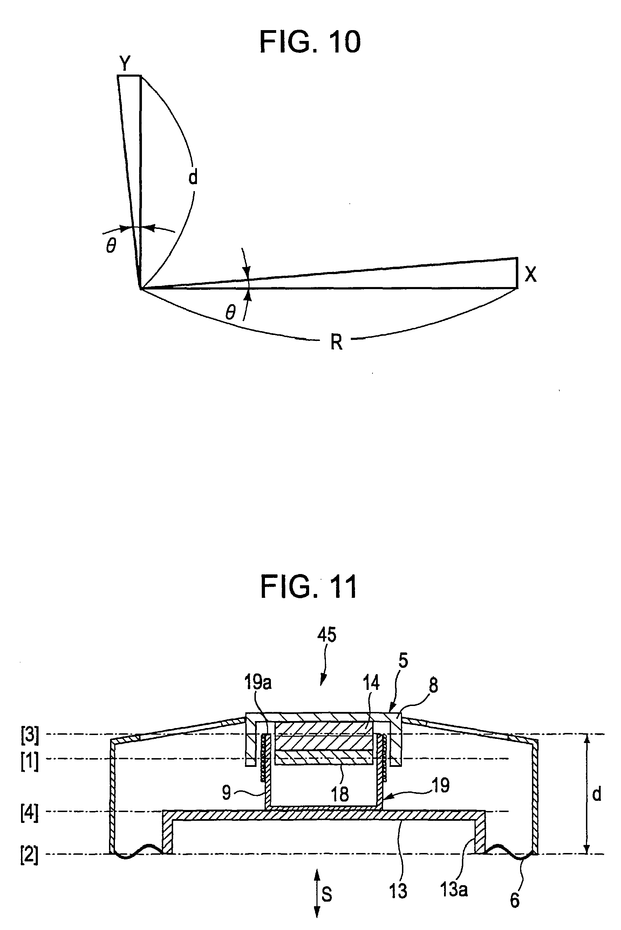

When the point P is displaced by X, the rotation of the vibrating plate 3 is substantially centered on the point O. As shown in Fig. 10, when the vibrating plate 3 rotates around the point O by an angle θ, the right triangle RX and the right triangle dY are homologous. Therefore, the displacement Y can be represented by the following formula:

$$Y \approx (d \cdot X)/R \qquad (1)$$

Since the displacement Y is extremely small, the displacement depending on r (for example, the upward displacement of the tip 19a of the voice coil body 19 in the drawing caused by the rotation of the vibrating plate 3 due to tilting, as shown in Fig. 9) can be ignored. Consequently, Formula 1 is a satisfactory approximation to the displacement Y.

A margin m for the voice coil body 19 in the space G can be represented by the following formula:

$$m = (G-t)/2 \qquad (2)$$

where, m represents a margin on one side of the voice coil body 19. Here, it is assumed that the space G distributed equally on each side of the voice coil body 19. Depending on the design, either the inner margin or the outer margin may be larger than the other. In any way, if the displacement Y of the tip 19a of the voice coil body 19 exceeds the margin m, the tip 19a comes into contact with the magnetic circuit members. For the tip 19a to not contact the magnetic circuit members, the following relationship must hold:

$$Y < m \qquad (3)$$

Therefore, from Formulas 1, 2, and 3, the following relationship holds:

$$[(d \cdot X)/R] < [(G-t)/2] \qquad (4)$$

In other words, for the tip 19a to not contact the magnetic circuit members, the distant d should satisfy the following:

$$d < [(G-t)R]/(2X) \qquad (5)$$

According to Formula 5, the smaller the distance d from the second position [2] at a support surface where the vibrating plate 3 is supported by the elastic supporting member 6 to the tip 19a, the less likely the voice coil body 19 comes into contact with the magnetic circuit members. If the displacement X is about 0.5 mm, which is a realistic value, the distance d will satisfy the following relationship:

$$d < (G-t)R \qquad (6)$$

The displacement X will be about 0.5 mm when the length R is in the range of 10 to 40 mm or 15 to 35 mm.

Here, the distance d was calculated from the dimensions of a vibrating device actually produced by the inventor. The dimensions of the vibrating device produced by the inventor were G=0.94 mm, t=0.35 mm, R=22 mm, and r=8 mm, and d=13 mm. By setting the distance d below 13 mm in an actuator produced by the inventor, noise caused by the voice coil body 19 coming into contact with the magnetic circuit members was prevented even when only one elastic supporting member 6 was provided. According to an experiment, noise was reliably reduced and the quietness of the apparatus was improved. The distance d may be in the range of 0 to 20 mm or, more desirably, 0 to 10 mm when the length R is in the range of 10 to 40 mm.

These values depend on the dimensions and margins of the components of the vibrating device 15. However, when the vibrating device 15 is to be used in a laptop PC, as mentioned above, it is desirable for the distance d to be 20 mm or less or, more desirably, 10 mm or less.

As described above, according to this embodiment, the voice coil body 19 can be prevented from coming into contact with the magnetic circuit members while the vibrating plate 3 is vibrating by setting the distance d to a suitable value. In this way, noise can be suppressed while maintaining a predetermined air discharge amount without reducing the frequency and amplitude of the vibrating plate 3. In other words, according to this embodiment, as described above, noise caused by horizontal vibration can be prevented while maintaining an amplitude similar to a woofer speaker although the diameter of the vibrating plate 3 is relatively small.

Moreover, since only one elastic supporting member 6 is required, electric power consumption is low, the structure is simple, and weight is reduced. Furthermore, the durability of the actuator 5 is increased since the voice coil body 19 and the magnetic circuit members do not come into contact.

In the above, the length R is in the range of 10 to 40 mm but is not limited thereto. As a small electronic apparatus including the vibrating device 15 and the jet flow generating apparatus 10 according to this embodiment, an audio player including a flash memory and a hard disk or an IC voice recorder may be realized. As a large electronic apparatus including the vibrating device 15 and the jet flow generating apparatus 10 according to this embodiment, a 20-inch display device, 30-inch display device, or a display device larger 50 inches may be realized. Accordingly, the length R may be in the range of 5 to 100 mm. When the length R is greater than 40 mm, it is desirable to drive the vibrating plate 3 with an amplitude greater than 4 mmp-p, as described above.

Fig. 11 illustrates a cross-sectional view of a vibrating device according to another embodiment of the present invention. The structure of a vibrating plate 13 of a vibrating device 45 according to this embodiment includes a side plate 13a and has the same structure, for example, as that of the vibrating plate 13 shown in Fig. 6. The lower edge of the side plate 13a is supported by an elastic supporting member 6 on a support surface at a second position [2]. A tip 19a of a voice coil body 19 is positioned at a third position [3], as shown in Fig. 11. In this case, also, the vibrating device 45 is formed so that the distance d between the second position [2] and the third position [3] satisfies Formula 5 or 6, described above. In this way, the voice coil body 19 can be prevented from coming into contact with magnetic circuit members, such as a magnet 14, a cylindrical yoke 8, and a flat yoke 18. According to the structure such as that shown in Fig. 11, the distance d is relatively large because the support surface (i.e., second position [2]) is at a position further away from the voice coil body 19 relative to an attachment surface (i.e., fourth position [4]) where a coil bobbin 9 is attached to the vibrating plate 13. In other words, the support surface (i.e., second position [2]) is positioned at the lower edge of the side plate 13a. It is desirable that the distance d is minimized so that Formula 5 or 6 is satisfied. The smaller the distance d, the less likely the voice coil body 19 comes into contact with the magnetic circuit members.

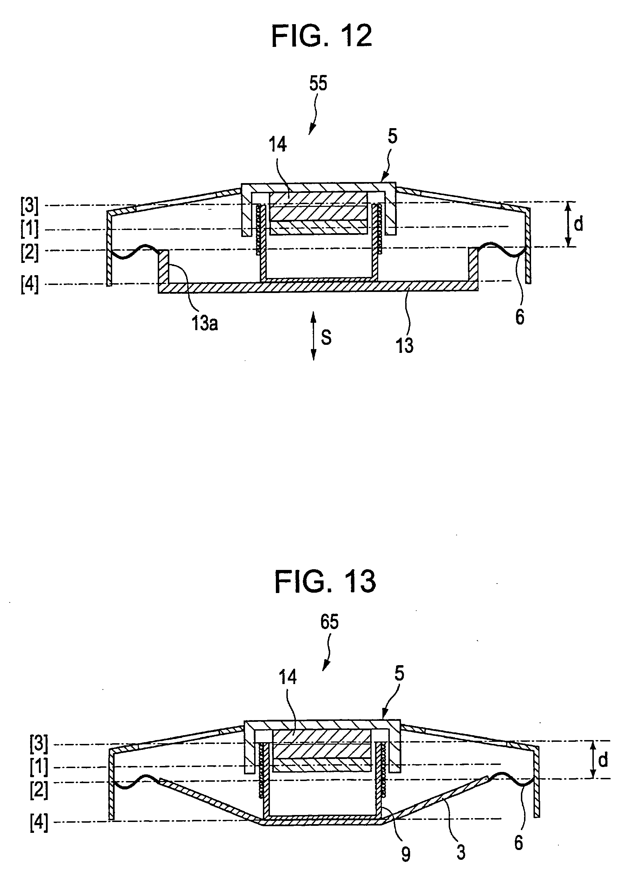

Accordingly, as shown in Fig. 12 illustrating a vibrating device 55 according to another embodiment of the present invention, a vibrating plate 13 may be set so that is faces a direction opposite to that shown in Fig. 11 relative to the vibration direction S. When the vibrating plate 13 faces the opposite direction, a side plate 13a is vertically disposed upward in the drawing so that a support surface (i.e., second position [2]) is provided at the upper edge of the side plate 13a. In this way, the distance d can be reduced compared to that shown in Fig. 11. When the vibrating plate is shaped as a cone, the support surface (i.e., second position [2]) can be provided at the upper edge of the vibrating plate, as the vibrating plate 3 shown in Fig. 3. In this way, the distance d can be reduced. The vibrating device 55 shown in Fig. 12 and a vibrating device 65 shown in Fig. 13 are thin and the voice coil body is prevented from coming into contact with the magnetic circuit members.

In the following descriptions, a position where a coil bobbin 9 is mounted on a vibrating plate 3 is defined as a fourth position [4]. In the following, the fourth position [4] is further away from a magnet 24 than a second position [2]. However, for the vibrating devices shown in Figs. 8 and 11, the fourth position [4] is closer to the magnet 14 than the second position [2].

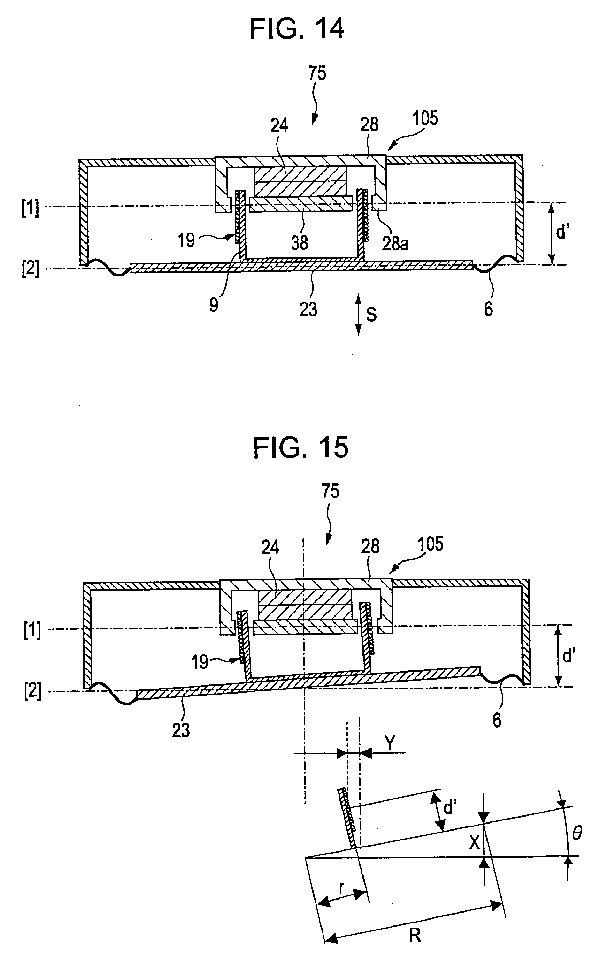

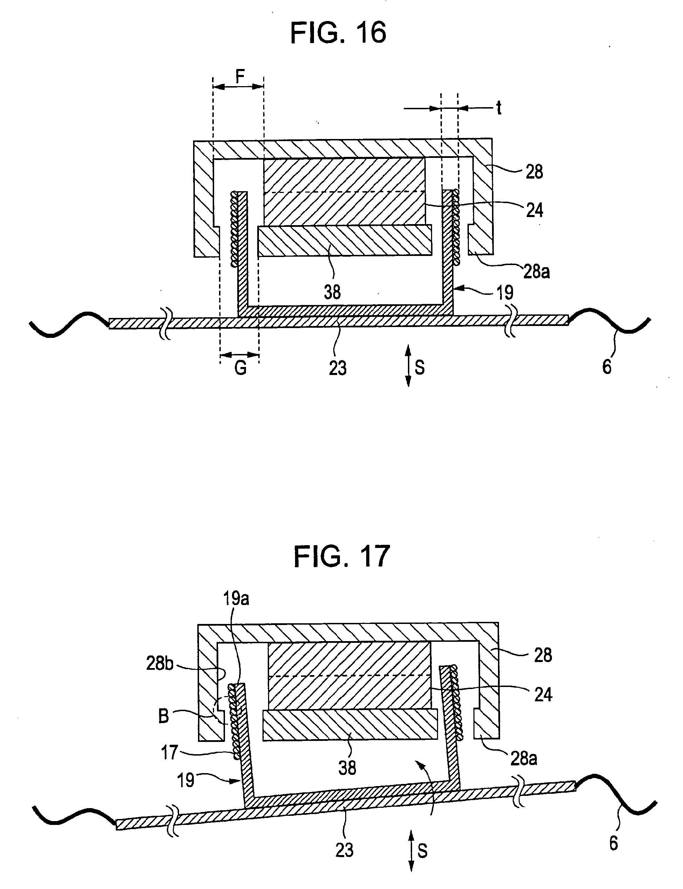

Fig. 14 illustrates a cross-sectional view of a vibrating device according to another embodiment of the present invention. Fig. 16 illustrates an enlarged cross-sectional view of an actuator 105 of the vibrating device shown in Fig. 14. A vibrating plate 23 included in a vibrating device 75 is shaped as, for example, a flat plate. If the vibrating plate 23 is flat, the position where the vibrating plate 23 is supported by an elastic supporting member 6 (i.e., second position [2]) is substantially the same as the position where a coil bobbin 9 is attached to the vibrating plate 23 (i.e., the above-described fourth position). Since the vibrating plate 23 is flat, its structure is simple. A simple structure prevents air from swirling when the vibrating plate 23 vibrates and generates a pressure difference in the chambers. As a result, noise caused by an air flow can be reduced.

A plate-shaped yoke 38 that is disposed on the magnet 24 of the vibrating device 75 has a diameter greater than that of the magnet 24. A yoke 28 for accommodating the magnet 24 is, for example, cylindrical and, as shown in Fig. 16, a protruding part 28a protrudes inward to form a magnetic gap G. In this case, the magnetic gap G is minimized so that it is smaller than the width F of the gap between the magnet 24 and an inner circumferential surface 28b of an inner circumferential surface 28b of the cylindrical yoke 28. In this case, for example, if the vibrating plate 23 is tilted due to horizontal vibration, as shown in Figs. 15 and 17, part of a coil 17 of a voice coil body 19 contacts the protruding part 28a at a position indicated by a dotted circle B shown in Fig. 17. A tip 19a of the voice coil body 19 might contact the inner circumferential surface 28b, but before that, the coil 17 of the voice coil body 19 contacts the protruding part 28a in the circle B. In this way, the displacement Y (refer to Fig. 15) of the voice coil body 19 is smaller at parts of the voice coil body 19 that are closer to the support surface (i.e., second position [2]) of the vibrating plate 23 supported by the elastic supporting member 6. Such a structure provides a greater margin for the tilt of the vibrating plate 23. Depending on the size of the magnetic gap G, the voice coil body 19 is less likely to come into contact with the protruding part 28a in the circle B than the tip 19a of the voice coil body 19 coming into contact with the magnetic circuit members.

As shown in Fig. 14, in the vibrating device 75, the center position of the plate-shaped yoke 38 that is disposed on the magnet 24 in the vibration direction S is defined as a first position [1]. If the distance between the fist position [1] and a second position [2] is represented by d', the voice coil body 19 does not come into contact with the magnetic circuit members if the following formula, which is similar to Formula 5, is satisfied:

$$d' < [(G-t)R]/(2X) \qquad (7)$$

In general, it is easy to design the vibrating device 75 so that the distance d' is smaller than the distance d. According to such a design, the displacement of the voice coil body 19 is small, but the margin for the tilt is great. Similar to Formula 6, when a realistic value is assigned to the displacement X, the following relationship holds for the distance d':

$$d' < (G-t)R \qquad (8)$$

In order to easily compare Figs. 8 and 16, the distance d' is also shown in Fig. 8. Furthermore, the first position [1] is also shown in Figs. 11 to 13.

The distance d' is in the range of 0 to 10 mm or, more desirably, 0 to 5 mm when the length R is in the range of 10 to 40 mm.

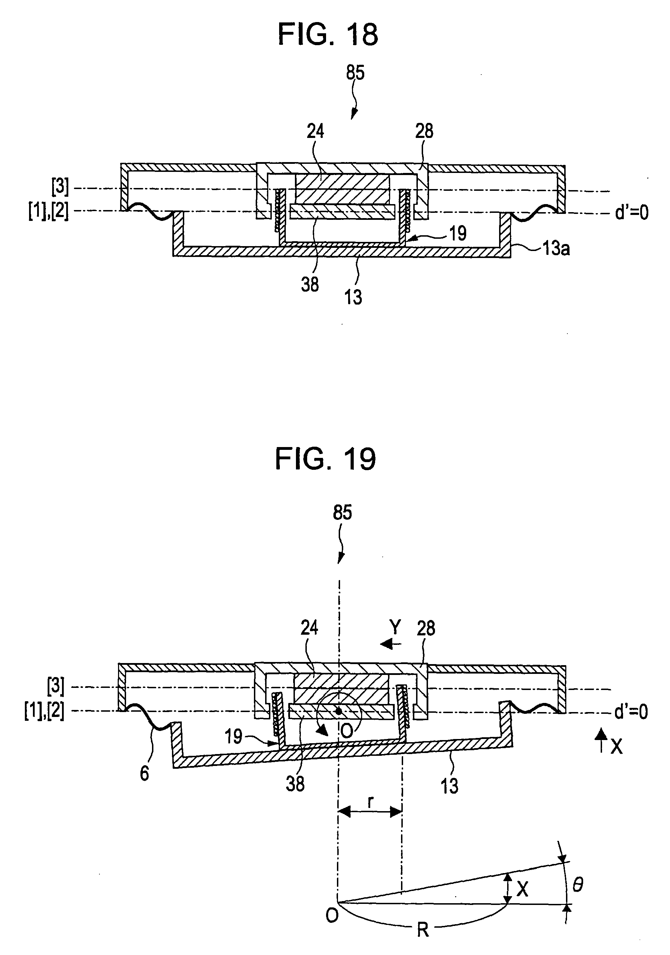

To increase the margin for the tilting of the vibrating plate 23 in the vibrating device 75, which has the structure shown in Fig. 14, the attachment position (i.e., first position [1]) of the plate-shape yoke 38 and the supporting position (i.e., second position [2]) of the vibrating plate 23 should be moved closer together. In other words, the vibrating device should be designed so that the distance d' equals zero, as shown in Fig. 18 illustrating a vibrating device 85 according to another embodiment of the present invention. The vibrating device 85 includes a vibrating plate 13 whose side plate 13a is supported by an elastic supporting member 6 at the upper edge of the side plate 13a.

Fig. 19 illustrates a vibrating plate of the vibrating device 85 shown in Fig. 18 at a tilted state caused by horizontal vibration. In this case, the angle θ can be represented as the following:

$$\theta = \tan^{-1}(X/R) \qquad (9)$$

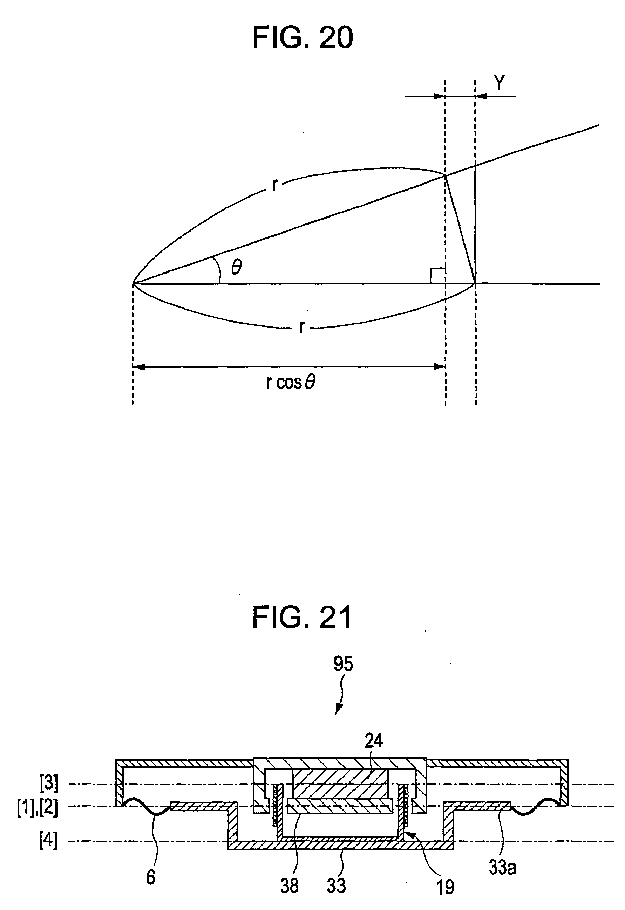

As shown in Fig. 20, the displacement Y of a voice coil body 19 at the magnetic gap of a cylindrical inner circumferential surface 28b and a plate-shaped yoke 38 (i.e., distance r measured from the center O) of the enlarged triangle, which is shown in the lower area of Fig. 19, can be represented by the following formula, although the displacement Y is ignored in Formula 7:

$$Y = r(1 - \cos\theta) \qquad (10)$$

The structures shown in Fig. 8 and 9 also satisfy Formula 10.

Here, similar to the above, if G=0.94 mm, t=0.35 mm, R=22 mm, and r=8 mm, from Formulas 9 and 19, θ=1.3° and Y=2 μm. In other words, although the displacement of the voice coil body 19 at the magnetic gap can be substantially ignored, the vibrating device 85 has a structure that can reliably compensate for tilting. Accordingly, the magnetic gap G can be narrowed. As a result, the magnetic efficiency is improved, and the vibrating device 85 can be magnetically driven efficiently. Consequently, energy consumption is reduced.

Fig. 21 illustrates a cross-sectional view of a vibrating device 95 according to another embodiment of the present invention. A vibrating plate 33 of the vibrating device 95 includes a flange 33a at a position closer to a magnet 24 than the position where a voice coil body 19 is disposed. The vibrating plate 33 is supported by an elastic supporting member 6 at the position where the flange 33a is disposed (i.e., second position [2]). A first position [1] and the second position [2] are the same positions. By using the vibrating plate 33, the distance d' can be set to zero.

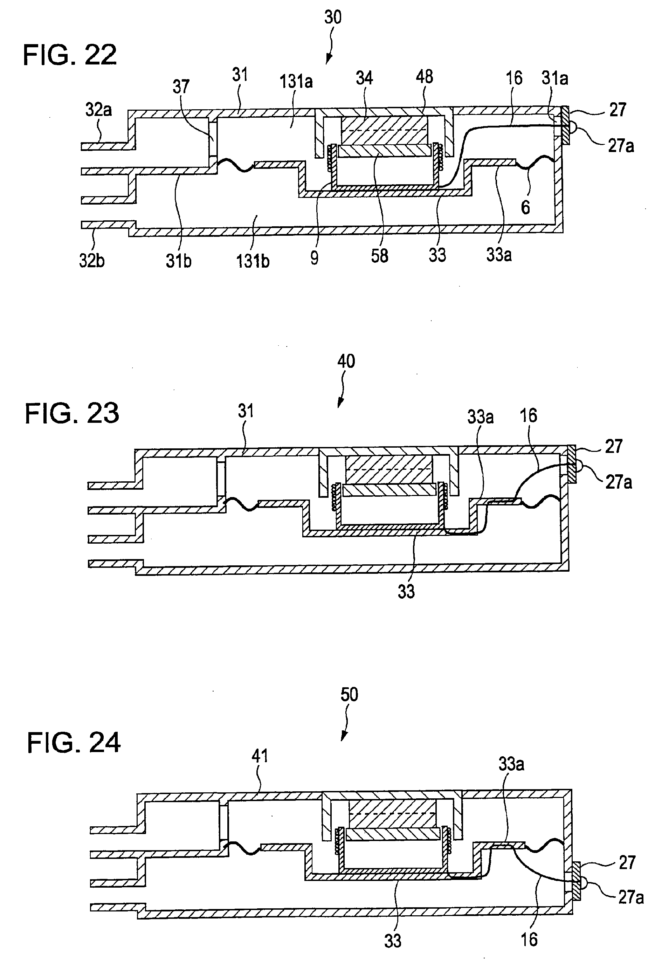

Fig. 22 illustrates a cross-sectional view of a jet flow generating apparatus 30 according to another embodiment of the present invention. The jet flow generating apparatus 30 includes a chassis 31 having nozzles 32a and 32b on which a vibrating plate 33 is supported by an elastic supporting member 6. The vibrating plate 33 includes, for example, a flange 33a having the same structure as that of the above-described flange 33a. Instead of providing both the nozzles 32a and 32b, either the nozzles 32a or the nozzles 32b may be provided. However, it is desirable to provide the plurality of nozzles 32a or 32b, whichever is provided, along the direction perpendicular to the surface of the drawing. Inside the chassis 31, chambers 131a and 131b are defined by a bulkhead 31b, the elastic supporting member 6, and the vibrating plate 33. A communication hole 37 is formed in the bulkhead 31b. The communication hole 37 may be an elongated hole, a circular hole, or any other shape. Moreover, a plurality of communication holes 37 may be provided.

A cylindrical yoke 48 is fixed on the chassis 31. A frame having the same structure as that of the frame 4 (refer to Fig. 2) of the above-described vibrating device 15 is not included in the cylindrical yoke 48, and the chassis 31 includes the functions of a frame. In other words, the elastic supporting member 6 is attached to the chassis 31. In this way, the number of components is reduced, the size of the apparatus is reduced, and the thickness of the apparatus is reduced, compared to the jet flow generating apparatus 10 illustrated in Figs. 1 and 2. An electric supply line 16 is connected to the voice coil body 19. Since the electric supply line 16 vibrates together with the vibrating plate 33, the electric supply line 16 must not break until the life of the jet flow generating apparatus 30 is expired. The required life of the jet flow generating apparatus 30 is several tens of thousand hours, and the total number of vibrations carried out is several billion times. Therefore, as shown in Fig. 22, it is desirable to connect the electric supply line 16 to a coil bobbin 9 and the chassis 31. To connect the electric supply line 16, a hole 31a is formed in the chassis 31. In this way, the electric supply line 16 is passed through the hole 31a and is connected to a terminal 27a included in a terminal block 27 that is fixed on the chassis 31.

Fig. 23 illustrates a cross-sectional view of a jet flow generating apparatus 40 according to another embodiment of the present invention. An electric supply line 16 of the jet flow generating apparatus 40 is disposed along a vibrating plate 33. The electric supply line 16 may be embedded in the vibrating plate 33 or may be disposed along the surface of the vibrating plate 33. Instead, the terminal block 27 may be provided at the lower area of a chassis 41 as shown in Fig. 24 illustrating a jet flow generating apparatus 50. Then, the electric supply line 16 may be disposed along the vibrating plate 33 and connected to a terminal block 27. According to such a structure, breaking of the electric supply line 16 can be prevented since one end of the electric supply line 16 is fixed to the terminal block 27 and the other parts of the electric supply line 16 is disposed along the vibrating plate 33.

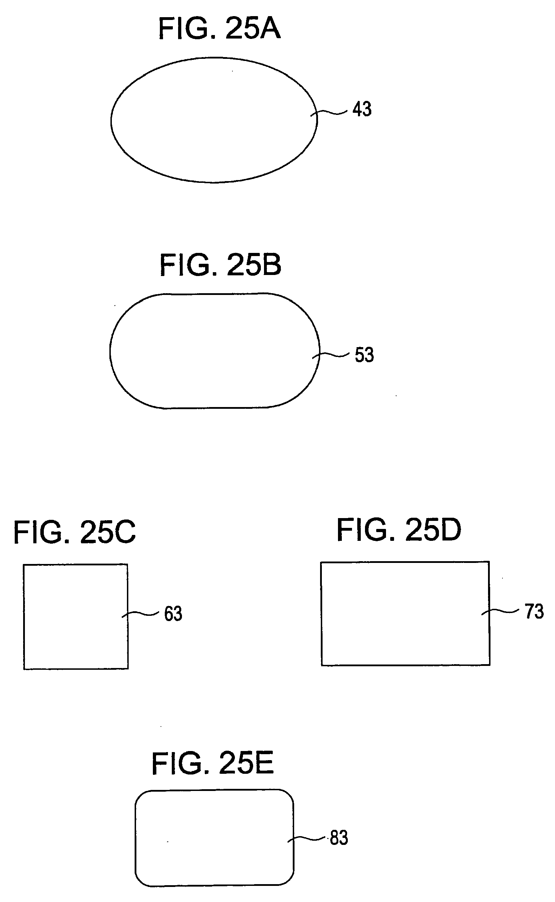

Figs. 25A to 25E illustrate the shapes of the cross-sections of vibrating plates according to another embodiment of the present invention, the vibrating plates having the same structures as the structures the above-described vibrating plates 3, 13, 23, and 33. The drawings show the cross-sectional view of the vibrating plates along a plane orthogonal to the vibration direction S. The shape of cross-sections of the vibrating plates may be oval, such as a cross-section 43 shown in Fig. 25A, or may be an elongated circle, such as a cross-section 53 shown in Fig. 25B. The cross-sections 63, 73, and 83 of vibrating plates shown in Figs. 25C to 25E, respectively, are a square, a rectangle, and a rectangle having rounded corners, respectively. In this way, the cross-sectional shape of a vibrating plate is not limited. However, if the cross-section is a circle, production, including production of a metal mold, is easy. When a vibrating device having the same structure as that of the vibrating device 15 having one of the cross-sections 63, 73, and 83 shown in Figs. 25C to 25E, respectively, is disposed in a chassis 1, it is desirable that the cross-sectional view of the chassis 1 is also rectangular to match the shape of the vibrating device. For example, an axial fan has a circular cross-section since the axial fan rotates to generate an air flow, whereas the vibrating device of the jet flow generating apparatus according to this embodiment does not have to be circular. Therefore, the vibrating device may employ various cross-sections, such as those shown in Figs. 25A to 25E. Since the cross-section of the vibrating device may vary, the flexibility of the position and shape of the vibrating device increases when the jet flow generating apparatus is disposed in an electronic apparatus, such as a PC.

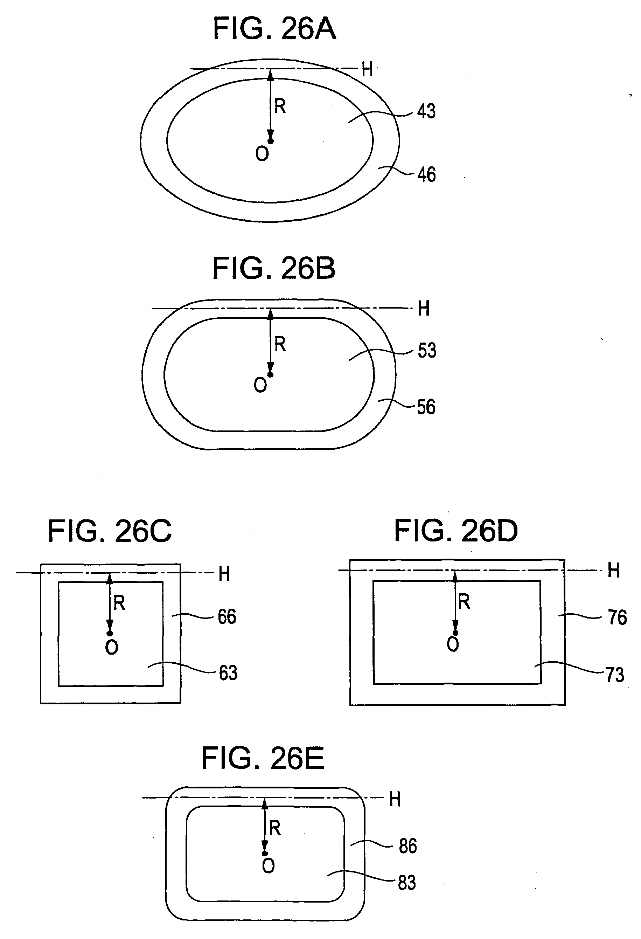

Figs. 26A to 26E illustrate the cross-sections shown in Fig. 25A to 25E with the above-described length R (refer to Fig. 8) applied. Cross-sections 46, 56, 66, 76, and 86 are cross-sections of the above-described elastic supporting member 6. The length R can be defined as the shortest distance from the center O to the center line H on the elastic supporting member 6. In this way, the distances d and d' can be applied to any type of cross-section.

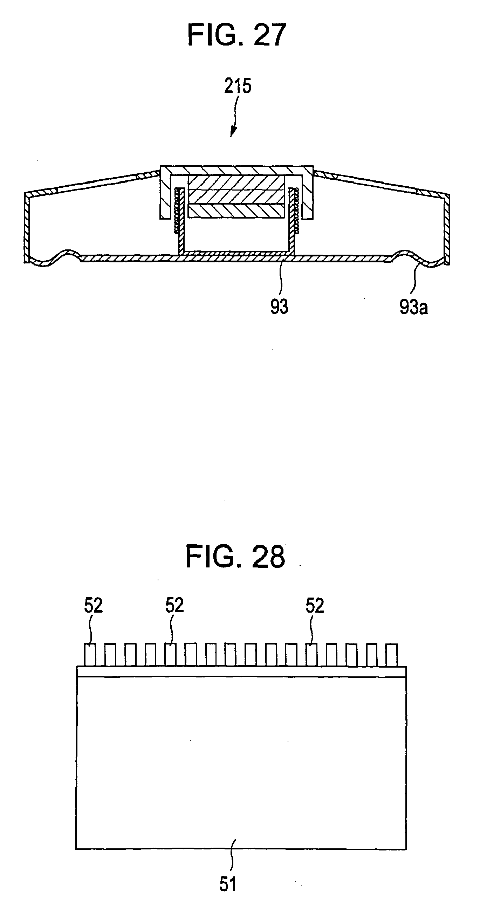

Fig. 27 illustrates a cross-sectional view of a vibrating device 215 according to another embodiment of the present invention. The vibrating device 215 includes a vibrating plate 93 and an elastic supporting member 93a that are composed as a single unit with the same material. The material may be resin or rubber. Since the vibrating plate 93 and the elastic supporting member 93a can be formed as a single unit, production costs can be reduced.

Fig. 28 illustrates a plan view of a chassis of a jet flow generating apparatus 50 according to another embodiment of the present invention. A chassis 51 of the jet flow generating apparatus 50 may be a prism, as shown in the drawing. In this case, the plan view of the vibrating plate, not shown in the drawing, may be various shapes, such as those shown in Figs. 25A to 25E. However, in order to efficiently generate a pressure difference inside the chassis 51, it is desirable to use a vibrating plate having the cross-section 73 shown in Fig. 25D or the cross-section 83 shown in Fig. 25E.

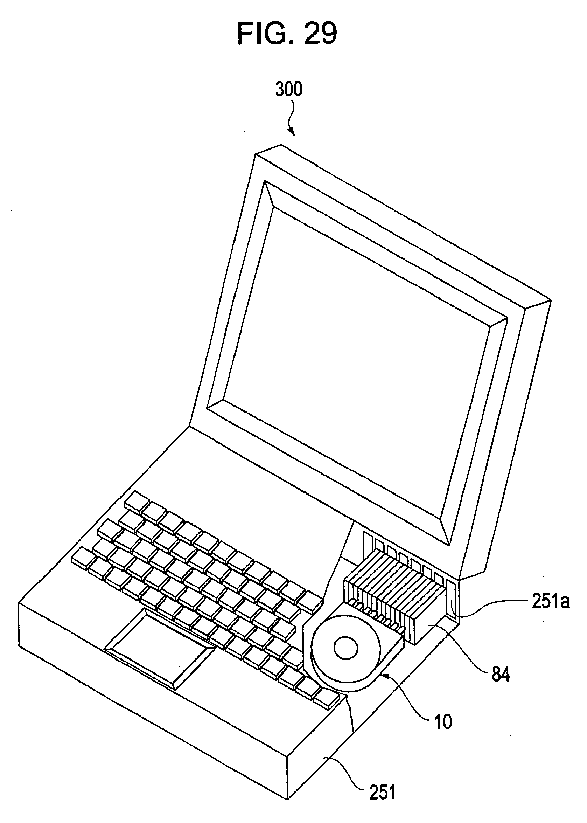

Fig. 29 illustrates a perspective view and a partial broken view of a laptop PC 300 including, for example, the jet flow generating apparatus 10 shown in Fig. 1. The PC 300 includes a heat sink 84 and the jet flow generating apparatus 10 configured to discharge air toward the heat sink 84. The air discharged from the jet flow generating apparatus 10 passes through the heat sink 84, then passes through a plurality of outlets 251a provided on the back side of a chassis 251, and is exhausted to the outside of the chassis 251.

It should be understood by those skilled in the art that various modifications, combinations, sub-combinations and alterations may occur depending on design requirements and other factors insofar as they are within the scope of the appended claims or the equivalents thereof.

**Claims**

1. A vibrating device configured to vibrate a gas inside a chassis to discharge the gas in a pulsating flow through an opening formed in the chassis, the vibrating device comprising:

   a frame;
   a vibrating plate;
   a supporting member attached to the frame, the supporting member being configured to support the vibrating plate in a manner such that the vibrating plate is vibratable; and
   a driving mechanism configured to drive the vibrating plate, the driving mechanism including,

   a magnetic circuit member attached to the frame, and
   a voice coil body attached to the vibrating plate and configured to prevent the voice coil body from contacting the magnetic circuit member when the vibrating plate is vibrating, the voice coil body being movable by means of a magnetic field generated by the magnetic circuit member.

2. The vibrating device according to Claim 1, wherein, the magnetic circuit member includes,

a magnet magnetized in the vibration direction of the vibrating plate, and
a yoke having,
a magnetic plate attached to the vibrating plate side of the magnet at a first position along the vibration direction, and
a magnetic cylinder forming a magnetic gap between the magnet plate and forming a space between the magnet, wherein
the voice coil body includes a tip, a coil, and a bobbin on which the coil is wound, and
the voice coil body moves in the vibration direction in the space to prevent at least one of the tip and the coil from coming into contact with the magnetic circuit member.

3. The vibrating device according to Claim 2, wherein,
the supporting member supports the vibrating plate at a second position along the vibration direction, the second position being a position on a plane substantially orthogonal to the vibration direction of the vibrating plate and,
the tip of the voice coil body is disposed at a third position a predetermined distance away from the second position in the vibration direction, and
the predetermined distance is determined from a function of a third length, the third length being the sum of a first length and a second length, the first length being the minimum length from the center of the vibrating plate to the peripheral edge on the plane, the second length being half the length from the peripheral edge to the frame in the same direction as the first length.

4. The vibrating device according to Claim 3, wherein

$$d < [(G-t)R]/(2X)$$

is satisfied, where d [mm] represents the predetermined distance, R [mm] represents the third length, G [mm] represents the magnetic gap, t [mm] represents the thickness of the voice coil body in the space, and X [mm] represents the displacement in the vibration direction of the supporting member when the vibrating plate moves in a direction other than the vibration direction, the supporting member being disposed away from the center of the vibrating plate by a distance equal to the third length.

5. The vibrating device according to Claim 4, wherein the third length R is in the range of 5 to 100 mm.

6. The vibrating device according to Claim 4, wherein, when the third length R is in the range of 10 to 40 mm, the predetermined distance d is 0 to 10 mm.

7. The vibrating device according to Claim 2, wherein,
the supporting member supports the vibrating plate at a second position, the second position being a predetermined distance away from the first position in the vibration direction on a plane substantially orthogonal to the vibration direction, and
when the magnetic gap is smaller than the width of the space on the plane, the predetermined length is determined from a function of a third length, the third length being the sum of a first length and a second length, the first length being the minimum length from the center of the vibrating plate to the peripheral edge on the plane, the second length being half the length from the peripheral edge to the frame in the direction of the first length.

8. The vibrating device according to Claim 7, wherein

$$d < [(G-t)R]/(2X)$$

is satisfied, where d [mm] represents the predetermined distance, R [mm] represents the third length, G [mm] represents the magnetic gap, t [mm] represents the thickness of the voice coil body in the space, and X [mm] represents the displacement in the vibration direction of the supporting member when the vibrating plate moves in a direction other than the vibration direction, the supporting member being disposed away from the center of the vibrating plate by a distance equal to the third length.

9. The vibrating device according to Claim 7, wherein the third length R is in range of 5 to 100 mm.

10. The vibrating device according to Claim 7, wherein, when the third length R is in range of 10 to 40 mm, the predetermined distance d is in range of 0 to 10 mm or 0 to 5 mm.

11. The vibrating device according to Claim 3, wherein the voice coil body is attached to the vibrating plate at a fourth position along the vibrating direction, the fourth position being a position different from the second position.

12. The vibrating device according to Claim 11, wherein the fourth position is closer to the magnet than the second position or the fourth position is further from the magnet than the second position.

13. The vibrating device according to Claim 11, wherein the vibrating plate includes,
a side plate supported by the supporting member, and
a flat plate attached to the voice coil body.

14. The vibrating device according to Claim 11, wherein the vibrating plate includes,
a first flat plate supported by the supporting member, and
a second flat plate attached to the voice coil body, the second flat plate being substantially parallel to the first flat plate.

15. The vibrating device according to Claim 11, wherein the vibrating plate is shaped as a cone so that the diameter of the vibrating plate gradually increases in the vibration direction.

16. The vibrating device according to Claim 3, wherein the voice coil body is attached to the vibrating plate at substantially the same position as the second position in the vibration direction.

17. The vibrating device according to Claim 13, wherein the driving mechanism includes an electric supply line connected to the voice coil body, the electric supply line being disposed along the side plate and the flat plate.

18. The vibrating device according to Claim 14, wherein the driving mechanism includes an electric supply line connected to the voice coil body, the electric supply line being disposed along the first flat plate and the second flat plate.

19. The vibrating device according to Claim 7, wherein the voice coil body is attached to the vibrating plate at a fourth position in the vibration direction, the fourth position being a position different from the second position.

20. The vibrating device according to Claim 19, wherein the fourth position is closer to the magnet than the second position or the fourth position is further from the magnet than the second position.

21. The vibrating device according to Claim 20, wherein the vibrating plate includes,
a side plate supported by the supporting member, and
a flat plate attached to the voice coil body.

22. The vibrating device according to Claim 20, wherein the vibrating plate includes,
a first flat plate supported by the supporting member, and
a second flat plate attached to the voice coil body, the second flat plate being substantially parallel to the first flat plate.

23. The vibrating device according to Claim 20, wherein the vibrating plate is shaped as a cone so that the diameter of the vibrating plate gradually increases in the vibration direction.

24. The vibrating device according to Claim 7, wherein the voice coil body is attached to the vibrating plate at substantially the same position as the second position along the vibration direction.

25. The vibrating device according to Claim 21, wherein the driving mechanism includes an electric supply line connected to the voice coil body, the electric supply line being disposed along the side plate and the flat plate.

26. The vibrating device according to Claim 22, wherein the driving mechanism includes an electric supply line connected to the voice coil body, the electric supply line being disposed along the first flat plate and the second flat plate.

27. The vibrating device according to Claim 1, wherein the cross-section of vibrating plate along a plane substantially orthogonal to the vibration direction is shaped as one of a circle, an oval, a polygon, and a polygon with rounded corners.

28. The vibrating device according to Claim 1, wherein the supporting member is composed of one of rubber and resin.

29. The vibrating device according to Claim 1, wherein the vibrating plate and the supporting member are composed of the same material.

30. A jet flow generating apparatus comprising:

a frame;
a chassis having an opening, the chassis being configured to support the frame and accommodate gas inside;
a vibrating plate configured to vibrate to discharge the gas in a pulsating flow through the opening;
a supporting member attached to the frame, the supporting member being configured to support the vibrating plate in a manner such that the vibrating plate is vibratable; and
a driving mechanism configured to drive the vibrating plate, the driving mechanism including,

a magnetic circuit member attached to the frame, and
a voice coil body attached to the vibrating plate and configured to prevent the voice coil body from contacting the magnetic circuit member when the vibrating plate is vibrating, the voice coil body being movable by means of a magnetic field generated by the magnetic circuit member.

31. A jet flow generating apparatus comprising:

a chassis having an opening, the chassis accommodating gas inside;
a vibrating plate configured to vibrate to discharge the gas in a pulsating flow through the opening;
a supporting member attached to the chassis, the supporting member being configured to support the vibrating plate in a manner such that the vibrating plate is vibratable; and
a driving mechanism configured to drive the vibrating plate, the driving mechanism including,

a magnetic circuit member attached to the chassis, and
a voice coil body attached to the vibrating plate and configured to prevent the voice coil body from contacting the magnetic circuit member when the vibrating plate is vibrating, the voice coil body being movable by means of a magnetic field generated by the magnetic circuit member.

32. An electronic apparatus comprising:

a heat-generating body;
a frame;
a chassis having an opening, the chassis being configured to support the frame and accommodate gas inside;
a vibrating plate configured to vibrate to discharge the gas in a pulsating flow through the opening toward the heat-generating body;
a supporting member attached to the frame, the supporting member being configured to support the vibrating plate in a manner such that the vibrating plate is vibratable; and
a driving mechanism configured to drive the vibrating plate, the driving mechanism including,

a magnetic circuit member attached to the frame, and
a voice coil body attached to the vibrating plate and configured to prevent the voice coil body from contacting the magnetic circuit member when the vibrating plate is vibrating, the voice coil body being movable by means of a magnetic field generated by the magnetic circuit member.

33. An electronic apparatus comprising:

a heat-generating body;
a chassis having an opening, the chassis accommodating gas inside;
a vibrating plate configured to vibrate to discharge the gas in a pulsating flow through the opening toward the heat-generating body;
a supporting member attached to the chassis, the supporting member being configured to support the vibrating plate in a manner such that the vibrating plate is vibratable; and
a driving mechanism configured to drive the vibrating plate, the driving mechanism including,

a magnetic circuit member attached to the chassis, and

a voice coil body attached to the vibrating plate and configured to prevent the voice coil body from contacting the magnetic circuit member when the vibrating plate is vibrating, the voice coil body being movable by means of a magnetic field generated by the magnetic circuit member.

**34.** A speaker apparatus comprising:

a frame;

a vibrating plate;

a supporting member attached to the frame, the supporting member being configured to support the vibrating plate in a manner such that the vibrating plate is vibratable; and

a driving mechanism configured to drive the vibrating plate, the driving mechanism including,

a magnetic circuit member attached to the frame, and

a voice coil body attached to the vibrating plate and configured to prevent the voice coil body from contacting the magnetic circuit member when the vibrating plate is vibrating, the voice coil body being movable by means of a magnetic field generated by the magnetic circuit member.

# FIG. 1

# FIG. 2

## FIG. 3

## FIG. 4

FIG. 5

20

5    15
2    4
3
6
11   21

FIG. 6

25

5
6
6
13a  13  4
S

FIG. 7

35

5
26
3   4
S
6

# FIG. 8

EP 1 717 936 A2

# FIG. 9

EP 1 717 936 A2

# FIG. 10

# FIG. 11

EP 1 717 936 A2

## FIG. 12

## FIG. 13

# FIG. 14

# FIG. 15

## FIG. 16

## FIG. 17

# FIG. 18

85

24    28

[3]

[1],[2] ---- d'=0

19

13a

38    13

# FIG. 19

85

24    Y    28

[3]

[1],[2] ---- d'=0

X

19

6

38    13

r

X

θ

O

R

# FIG. 20

$$r \cos \theta$$

# FIG. 21

**FIG. 22**

**FIG. 23**

**FIG. 24**

## FIG. 25A

~ 43

## FIG. 25B

~ 53

## FIG. 25C

~ 63

## FIG. 25D

~ 73

## FIG. 25E

·83

## FIG. 26A

## FIG. 26B

## FIG. 26C

## FIG. 26D

## FIG. 26E

# FIG. 27

215

93　93a

# FIG. 28

52　52　52

51

# FIG. 29

300

251a

84

10

251

**EP 1 717 936 A2**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005130309 A
- JP 2000223871 A
- JP 2000114760 A
- JP 2213200 A
- JP 3116961 A